# EUROPEAN PATENT APPLICATION

(11) **EP 4 760 357 A1**
(43) Date of publication of application: **17.06.2026**
(21) Application number: 25214669.1
(22) Date of filing: 10.11.2025
(51) Int. Cl.: G02B 1/00, G02B 1/11, G02B 5/30, G02B 27/28

(54) **ELECTRONIC DEVICE**

(30) Priority: 16.12.2024 CN 202411847538
(71) Applicant: InnoLux Corporation, Chu-Nan, Miao-Li 350 (TW)
(72) Inventor: PING-HSUN, TSAI, Jhu-Nan 350 Miao-Li County (TW); I-AN, YAO, Jhu-Nan 350 Miao-Li County (TW)
(74) Representative: dompatent

(57) **Abstract**

An electronic device includes a first substrate, an electronic unit, a phase retardation layer, and a polarizing layer. The electronic unit is disposed on the first substrate. The phase retardation layer is disposed at one side of the electronic unit away from the first substrate, and includes a first portion and a second portion disposed adjacent to each other. The first portion has a first fast axis, and the second portion has a second fast axis. The polarizing layer is disposed at one side of the phase retardation layer away from the electronic unit, and has a transmission axis. The included angle between the first fast axis and the transmission axis is different from the included angle between the second fast axis and the transmission axis, or the phase retardation of the first portion is different from the phase retardation of the second portion.

## Description

### BACKGROUND

### Technology Field

The present invention relates to an electronic device and, in particular, to a display device.

### Description of Related Art

With the development of digital technology, display devices have been widely used in electronic devices of various applications of daily life, such as televisions, computers, mobile phones and other modern information products. Generally speaking, when a display device is not lighting (e.g. in power off status or screen power saving mode), its display surface is usually a pure black screen. However, in order to be combined with certain scenarios, such as in cars or exhibitions, it may be desired that when the display device is not lighting, the display surface does not show an entire black screen under the reflection of ambient light.

### SUMMARY

This invention provides an electronic device that can display a special color and/or pattern design instead of a black screen when the electronic device is not lighting.

An electronic device includes a first substrate, an electronic unit, a phase retardation layer and a polarizing layer. The first substrate is defined with a normal direction. The electronic unit is disposed on the first substrate. The phase retardation layer is disposed at one side of the electronic unit away from the first substrate. The phase retardation layer includes a first portion and a second portion disposed adjacent to each other in a direction perpendicular to the normal direction. The first portion has a first fast axis, and the second portion has a second fast axis. The polarizing layer is disposed at one side of the phase retardation layer away from the electronic unit, and the polarizing layer has a transmission axis. The included angle between the first fast axis and the transmission axis is different from the included angle between the second fast axis and the transmission axis.

An electronic device includes a first substrate, an electronic unit, a phase retardation layer and a polarizing layer. The first substrate is defined with a normal direction. The electronic unit is disposed on the first substrate. The phase retardation layer is disposed at one side of the electronic unit away from the first substrate. The phase retardation layer includes a first portion and a second portion disposed adjacent to each other in a direction perpendicular to the normal direction. The polarizing layer is disposed at one side of the phase retardation layer away from the electronic unit. The phase retardation of the first portion is different from the phase retardation of the second portion.

### BRIEF DESCRIPTION OF THE DRAWINGS

The invention will become more fully understood from the detailed description and accompanying drawings, which are given for illustration only, and thus are not limitative of the present invention, and wherein:
FIG. 1A and FIG. 1B are schematic sectional views of the electronic device according to a first embodiment of this invention;
FIG. 2A and FIG. 2B are schematic sectional views of the electronic device according to a second embodiment of this invention;
FIG. 3A and FIG. 3B are schematic sectional views of the electronic device according to a third embodiment of this invention;
FIG. 4A and FIG. 4B are schematic sectional views of the electronic device according to a fourth embodiment of this invention;
FIG. 5A and FIG. 5B are schematic sectional views of the electronic device according to a fifth embodiment of this invention;
FIG. 6A and FIG. 6B are schematic sectional views of the electronic device according to a sixth embodiment of this invention;
FIG. 7A and FIG. 7B are schematic sectional views of the electronic device according to a seventh embodiment of this invention; and
FIG. 8A and FIG. 8B are schematic sectional views of the electronic device according to an eighth embodiment of this invention.

### DETAILED DESCRIPTION OF THE INVENTION

It should be understood that the following description provides different embodiments for implementing different aspects of some embodiments of the present invention. The specific components and arrangements described below are used to briefly and clearly describe some embodiments of the present disclosure. These embodiments are for illustrations and are not intended to limit the scope of the present disclosure. In addition, reference numbers or labels may be repeatedly used in different embodiments. These repetitions are for the purpose of simply and clearly describing some embodiments of the present disclosure, and do not represent any correlation between the different embodiments and/or structures discussed. Furthermore, when it is mentioned that a certain layer is on or above another layer, the certain layer may directly contact another layer, or one or more other layers or films may be provided between the two layers, so that the certain layer may not directly contact another layer.

Relative terms, such as "lower" and "higher", or "bottom" and "top", may be used in following embodiments to describe the relative relationship of one component to another component in the drawings. It will be understood that if the device shown in the drawings is turned upside down, components described as being at the "lower" side would then be at the "higher" side.

The terms "about", "approximate" and "approximately" usually mean the variation within 20%, preferably within 10%, and more preferably within 5%, 3%, 2%, 1% or 0.5% of a given value or range. The given quantities here are approximate quantities, that is, in the absence of specific description of "about", "approximate", or "approximately", the meaning of "about", "approximate", and "approximately" can still be implied.

It will be understood that, although the terms "first", "second", "third" and the likes may be used herein to describe various elements, components, regions, layers, and/or portions, these elements, components, regions, layers, and/or portions should not be limited by these terms, and these terms are used to distinguish between different elements, components, regions, layers, and/or portions. Thus, a first element, component, region, layer, and/or portion discussed below could be termed a second element, component, region, layer, and/or portion without departing from the teachings of some embodiments of the present disclosure.

Unless otherwise defined, all terms (including technical and scientific terms) used herein have the same meaning as commonly understood by one of ordinary skill in the related art. It is understood that these terms, such as those defined in commonly used dictionaries, should be interpreted to have a meaning consistent with the relevant technology and the background or content of the present disclosure, and should not be interpreted in an idealized or overly formal way, unless otherwise defined in the embodiments of this disclosure.

Some embodiments of the present disclosure can be understood together with the drawings, and the drawings of the embodiments of the present disclosure are also regarded as part of the description of the embodiments of the present disclosure. It should be understood that the drawings of the embodiments of the present disclosure are not drawn to the actual scale of devices and components. The shapes and thicknesses of embodiments may be exaggerated in the drawings to clearly illustrate features of embodiments of the present disclosure. In addition, the structures and devices in the drawings are illustrated in a schematic manner in order to clearly demonstrate the features of the embodiments of the present disclosure.

In some embodiments of the present disclosure, relative terms such as "lower", "upper", "parallel", "vertical", "below", "above", "top", "bottom", etc., shall be understood as the orientations shown in this paragraph and related drawings. This relative terms are for convenience of explanation and does not mean that the device described needs to be manufactured or operated in a specific orientation. Terms related to joining and connecting, such as "connect", "joint", etc., unless otherwise defined, can mean that two structures are in direct contact, or they can also mean that the two structures are not in direct contact with one or more additional structures located therebetween. The terms related to joining and connecting two structures can also include the situation that both structures are movable, or both structures are fixed.

To be noted, without departing from the spirit of the present invention, the features in several different embodiments may be replaced, reorganized, or mixed to complete other embodiments.

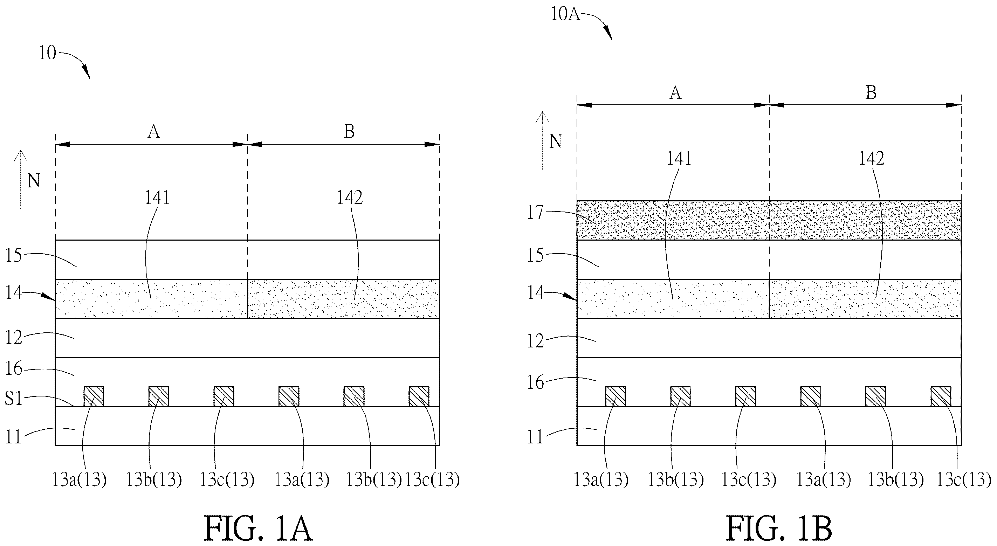

As shown in FIG. 1A, the electronic device 10 includes a first substrate 11, a second substrate 12, an electronic unit 13, a phase retardation layer 14, a polarizing layer 15, and an adhesive layer 16.

In this embodiment, the first substrate 11 is defined with a normal direction N. In details, the first substrate 11 may include a planarized surface S1, and the normal direction N is the direction perpendicular to the surface S1. In addition, the first substrate 11 may include, for example but not limited to, transparent or opaque organic materials and/or inorganic materials, and the material thereof may include rigid materials or flexible materials. The organic materials may include, for example but not limited to, polyimide (PI), polycarbonate (PC), polyethylene terephthalate (PET), other known suitable materials, or any combination of the above materials. Inorganic materials may include, for example but not limited to, glass, quartz, sapphire or ceramics. The materials of the first substrate 11 of this embodiment include glass as an example, so that the first substrate 11 is a glass substrate.

To be noted, a circuit layer (not shown), which usually includes metal traces with high reflective characteristics, may be provided on the first substrate 11. The circuit layer may include, for example, different passive components and/or active components, such as resistors, capacitors, inductors, diodes, MOSFETs, CMOS transistors, BJTs, LDMOS transistors, PMOS transistors, TFTs, or other types of transistors. In addition, the first substrate 11 and the circuit layer can together constitute a driving substrate for driving and/or controlling the electronic unit 13, which can be, for example but not limited to, a CMOS substrate, a LCOS substrate, a TFT substrate, or other circuit substrates with operating circuits. In this embodiment, the first substrate 11 and the circuit layer can together constitute, for example, a TFT substrate.

The second substrate 12 is disposed opposite to the first substrate 11, and can be, for example but not limited to, a transparent substrate, such as a glass substrate.

The electronic unit 13 is disposed on the surface (i.e., the surface S1) of the first substrate 11 facing the second substrate 12, and is located between the first substrate 11 and the second substrate 12. In this embodiment, the electronic unit 13 can be, for example but not limited to, a light-emitting unit, and the light-emitting unit (electronic unit 13) can be electrically connected to the circuit layer of the first substrate 11. In other embodiments, each electronic unit 13 may include any suitable active or passive components. In practice, for example, a pixel definition layer, which may be, for example, made of a negative photoresist and have a plurality of accommodation spaces, is first formed on the first substrate 11, and each light-emitting unit (electronic unit 13) may, for example, include three light-emitting elements 13a, 13b and 13c, which are respectively disposed in the accommodation spaces of the pixel definition layer. For example, each of the light-emitting elements 13a, 13b and 13c may include a light-emitting diode (LED), such as an organic LED (OLED), an inorganic LED (e.g. a mini LED or a micro LED), or a quantum-dot LED (QLED), but the present invention is not limited thereto. Each light-emitting element 13a, 13b or 13c generally has a certain reflective ability. For example, the LED has a reflectivity of more than 30%, and the OLED has a reflectivity of more than 60%. In this embodiment, the three light-emitting elements 13a, 13b and 13c of each light-emitting unit (electronic unit 13) may be, for example, a red micro LED, a green micro LED, and a blue micro LED, respectively. In fact, a plurality of electronic units 13 may be disposed on the first substrate 11. In other words, a micro LED array, which includes a plurality of micro LEDs arranged in an array, may be formed on the first substrate 11. In other embodiments, an organic LED array or an array of other light-emitting elements may be formed on the first substrate 11, and this invention is not limited thereto.

The adhesive layer 16 is disposed between the first substrate 11 and the second substrate 12. In this embodiment, the adhesive layer 16 may be, for example but not limited to, an optical clear adhesive (OCA) or an optical clear resin (OCR), etc., and this invention is not limited thereto. In one embodiment, when manufacturing the electronic device 10, the electronic unit 13 may be disposed on the first substrate 11, and then an adhesive material layer may be used to bond the structure of the first substrate 11 and the second substrate 12. The adhesive material layer may be, for example, an OCA or OCR, and the adhesive material layer can form the adhesive layer 16 after being cured.

The phase retardation layer 14 is disposed at one side of the electronic unit 13 away from the first substrate 11, and includes a first portion 141 and a second portion 142 disposed adjacent to each other in the direction perpendicular to the normal direction N. In the first aspect of the first embodiment, the first portion 141 has a first fast axis, and the second portion 142 has a second fast axis. In this embodiment, the phase retardation layer 14 is disposed at one side of the second substrate 12 away from the first substrate 11, the first portion 141 is correspondingly disposed in the region A, and the second portion 142 is correspondingly disposed in the region B. In this case, both the region A and the region B belong to the light-emitting region of the electronic device 10, and the region A and the region B may respectively include one or more light-emitting units (electronic unit 13). Specifically, each of the region A and the region B may include one or more pixels, and this invention is not limited thereto. It should be noted that the first portion 141 and the second portion 142 shown in FIG. 1A are merely exemplary. In actual applications, the first portion 141 and the second portion 142 may respectively include a preset pattern. For example, the preset pattern of the first portion 141 may be a plurality of parallel stripes, and the preset pattern of the second portion 142 may be a plurality of parallel stripes interposed between the parallel stripes of the preset pattern of the first portion 141. In another embodiment, the preset pattern of the first portion 141 may be a plurality of parallel stripes, wood grains, hairy lines, cloudy patterns, wavy stripes, or the likes, and the preset pattern of the second portion 142 may be the residual area other than the preset pattern of the first portion 141. In another embodiment, the preset pattern of the first portion 141 may be a specific pattern, such as a string of characters, an item picture, a trademark, a character graphic, or the likes, and the preset pattern of the second portion 142 may be the residual area other than the preset pattern of the first portion 141. The above description is only for an illustration and is not intended to limit the scope of the present invention. The preset patterns of the first portion 141 and/or the second portion 142 can be designed according to actual needs, and this invention is not limited thereto.

In this embodiment, the phase retardation layer 14 can be formed by, for example, the coating process, and can be patterned by the photolithography process or laser ablation process to form the first portion 141 and the second portion 142 having preset patterns. Specifically, in the manufacturing process of the phase retardation layer 14, a suitable solute can be placed in a solvent to form lyotropic liquid crystal solution. Herein, a typical solute may include an organic material (amphiphilic molecule) having both a hydrophilic group and a lipophilic group, such as alkali metal fatty salts (e.g. sodium dodecyl sulfate or sodium fatty acid), and the solvent may be water or other polar solvents. The desired liquid crystal form can be obtained by selecting the proper solvent and preparing the proper concentration of organic material. Then, the lyotropic liquid crystal solution is coated on the second substrate 12, and patterned by using, for example, photolithography process or laser ablation process to form the preset pattern of region A. After removing the residual solvent, the structure of the lyotropic liquid crystal can be fixed to form the first portion 141 of the phase retardation layer 14 in the region A. By selecting suitable solute and solvent and preparing a suitable concentration, the first portion 141 may have a first fast axis. Then, the second portion 142 of the phase retardation layer 14 in region B can be formed in the same manner, and the second portion 142 may have a second fast axis. It should be noted that the angle of the first fast axis and the angle of the second fast axis can be controlled by preparing the lyotropic liquid crystal solutions of different concentrations or different solutes. In addition, in the phase retardation layer 14, the liquid crystal molecules with fixed structures can be disc-like liquid crystal molecules, rod-like liquid crystal molecules, or rod-like chiral liquid crystal molecules, and this invention is not limited thereto. In this embodiment, the phase retardation of the first portion 141 for the incident ambient light can be the same as or different from the phase retardation of the second portion 142 for the incident ambient light, and this invention is not limited thereto.

The polarizing layer 15 is disposed at one side of the phase retardation layer 14 away from the electronic unit 13, and includes a transmission axis. The angle between the first fast axis of the first portion 141 of the phase retardation layer 14 and the transmission axis of the polarizing layer 15 is different from the angle between the second fast axis of the second portion 142 of the phase retardation layer 14 and the transmission axis of the polarizing layer 15. In this embodiment, the polarizing layer 15 is disposed on the upper surface of the phase retardation layer 14. For example, the polarizing layer 15 can be formed on the first portion 141 and the second portion 142 of the phase retardation layer 14 by a coating process. In some cases, the polarizing layer 15 can also be patterned by the photolithography process or laser ablation process. In details, in the manufacturing process of the polarizing layer 15, the lyotropic liquid crystals and the dichroic dye can be mixed, and then the mixed materials can be coated on the phase retardation layer 14. In this case, the color of the light allowed to pass through the polarizing layer 15 can be adjusted through the selection of the dichroic dye, and the color of the reflected light can be controlled.

As mentioned above, regardless of whether the phase retardations of the first portion 141 and the second portion 142 of the phase retardation layer 14 are the same or different, as long as the fast axis (first fast axis) of the first portion 141 can be controlled to be different from the fast axis (second fast axis) of the second portion 142, so that the angle between the first fast axis and the transmission axis is different from the angle between the second fast axis and the transmission axis, in cooperating with the high reflectivity of the electronic unit 13 and the circuit layer (e.g., including metal traces) of the first substrate 11, the area A corresponding to the first portion 141 and the area B corresponding to the second portion 142 can provide different reflected lights, such as different brightness and/or different colors. Therefore, when the electronic device 10 is not lighting, the aforementioned preset pattern, such as parallel stripes, wood grains, hairy lines, cloudy patterns, wavy stripes, a string of characters, an item picture, a trademark, a character graphic, etc., can be viewed from its outer side (e.g., display surface side).

In the second aspect of the first embodiment, as shown in FIG. 1A, the phase retardation layer 14 is disposed at one side of the electronic unit 13 away from the first substrate 11, and includes a first portion 141 and a second portion 142 disposed adjacent to each other in a direction perpendicular to the normal direction N. The polarizing layer 15 is disposed at one side of the phase retardation layer 14 away from the electronic unit 13. The phase retardation of the first portion 141 is different from the phase retardation of the second portion 142. It should be noted that, in this embodiment, the angle between the fast axis of the first portion 141 and the transmission axis of the polarizing layer 15 may be the same as or different from the angle between the fast axis of the second portion 142 and the transmission axis of the polarizing layer 15, and the invention is not limited thereto.

In this embodiment, the phase retardation layer 14 can be, for example, formed by a coating process, and can be patterned by the photolithography process or laser ablation process. After repeating the aforementioned patterning process several times, the first portion 141 and the second portion 142 constructing a preset pattern and being non-uniform can be formed. In other words, the phase retardation layer 14 can be a single-layer structure or a multi-layer structure, and the first portion 141 and the second portion 142 thereof may have different thicknesses (in the normal direction N) or numbers of layers, so as to form a non-uniform design of the first portion 141 and the second portion 142.

As mentioned above, regardless of whether the fast axis (first fast axis) of the first portion 141 of the phase retardation layer 14 and the fast axis (second fast axis) of the second portion 142 of the phase retardation layer 14 are the same or different, as long as the thickness or number of layers of the first portion 141 can be controlled to be different from the thickness or number of layers of the second portion 142, so that the first portion 141 and the second portion 142 have different phase retardations, in cooperating with the high reflectivity of the electronic unit 13 and the circuit layer (e.g., including metal traces) of the first substrate 11, the area A corresponding to the first portion 141 and the area B corresponding to the second portion 142 can provide different reflected lights, such as different brightness and/or different colors. Therefore, when the electronic device 10 is not lighting, the aforementioned preset pattern, such as parallel stripes, wood grains, hairy lines, cloudy patterns, wavy stripes, a string of characters, an item picture, a trademark, a character graphic, etc., can be viewed from its outer side (e.g., display surface side).

To be noted, one of the two aspects of the first embodiment described above is that the angle between the transmission axis and the first fast axis of the first portion 141 is different from the angle between the transmission axis and the second fast axis of the second portion 142, and the other aspect is that the phase retardation of the first portion 141 is different from the phase retardation of the second portion 142. These two features can be applied separately or simultaneously in any of following embodiments, and this invention is not limited thereto.

As shown in FIG. 1B, compared with the previous embodiment of FIG. 1A, the electronic device 10A further includes an anti-reflective layer 17, which is disposed at one side of the polarizing layer 15 away from the electronic unit 13. In this embodiment, the anti-reflective layer 17 may be, for example, a multilayer structure including one or more layers of high refractivity material and one or more layers of low refractivity material alternately arranged. Thus, the external ambient light passes through the anti-reflective layer 17 before entering the polarizing layer 15, thereby reducing the reflection of the external ambient light at the interface between the polarizing layer 15 and the air (as shown in FIG. 1A).

The detailed description of other features of the electronic device 10A can refer to the previous embodiment, and will be omitted here.

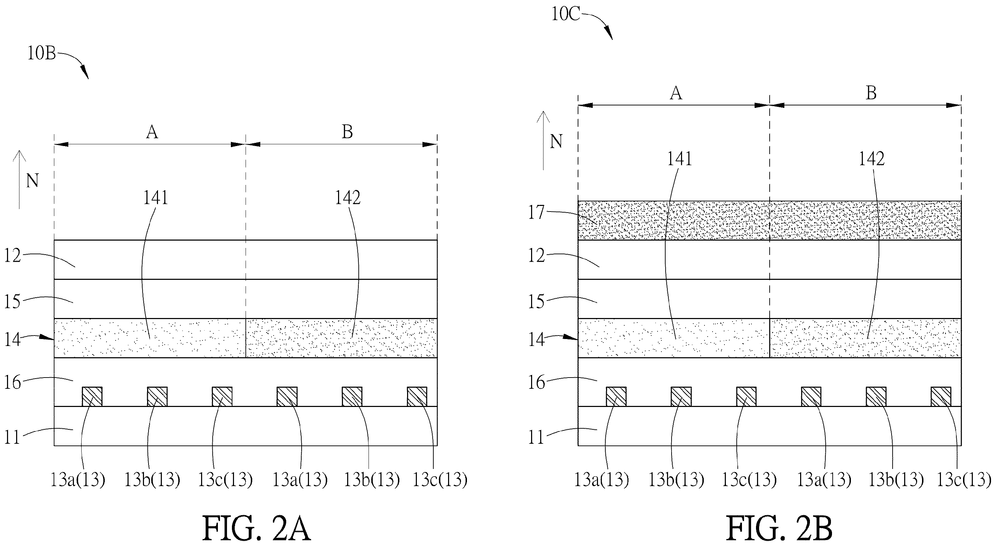

As shown in FIG. 2A, compared with the previous embodiment of FIG. 1A, in the electronic device 10B, the phase retardation layer 14 and the polarizing layer 15 are disposed between the first substrate 11 and the second substrate 12, the polarizing layer 15 is disposed between the phase retardation layer 14 and the second substrate 12, and the adhesive layer 16 is disposed between the first substrate 11 and the phase retardation layer 14.

The detailed description of other features of the electronic device 10B can refer to the previous embodiment, and will be omitted here.

As shown in FIG. 2B, compared with the previous embodiment of FIG. 2A, the electronic device 10C further includes an anti-reflective layer 17, which is disposed at one side of the second substrate 12 away from the electronic unit 13. The detailed description of other features of the electronic device 10C can refer to the previous embodiment, and will be omitted here.

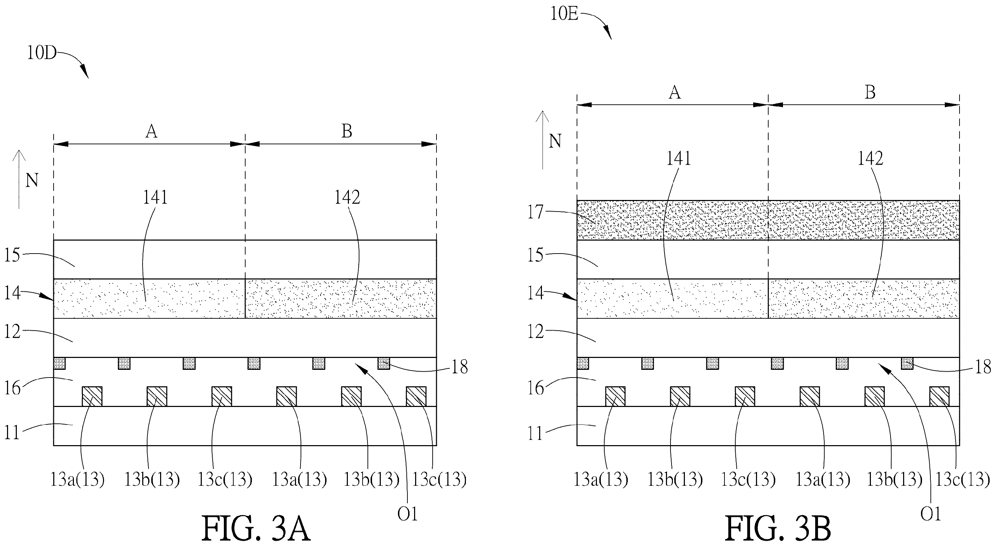

As shown in FIG. 3A, compared with the previous embodiment of FIG. 1A, the electronic device 10D further includes a black matrix layer 18, which is disposed between the electronic unit 13 and the phase retardation layer 14. The black matrix layer 18 includes a first opening O1, which overlaps the electronic unit 13 in the normal direction N of the first substrate 11. In details, the black matrix layer 18 can be, for example but not limited to, a black photoresist layer, which is disposed at one side of the second substrate 12 close to the electronic unit 13. In this case, the black matrix layer 18 includes a plurality of first openings O1, which are respectively disposed above the light-emitting elements 13a, 13b and 13c. In this embodiment, the main function of the black matrix layer 18 is to reduce the cross-talk between lights emitted from the light-emitting elements 13a, 13b and 13c (i.e., between the sub-pixels).

The detailed description of other features of the electronic device 10D can refer to the previous embodiment, and will be omitted here.

As shown in FIG. 3B, compared with the previous embodiment of FIG. 3A, the electronic device 10E further includes an anti-reflective layer 17, which is disposed at one side of the polarizing layer 15 away from the electronic unit 13. The detailed description of other features of the electronic device 10E can refer to the previous embodiment, and will be omitted here.

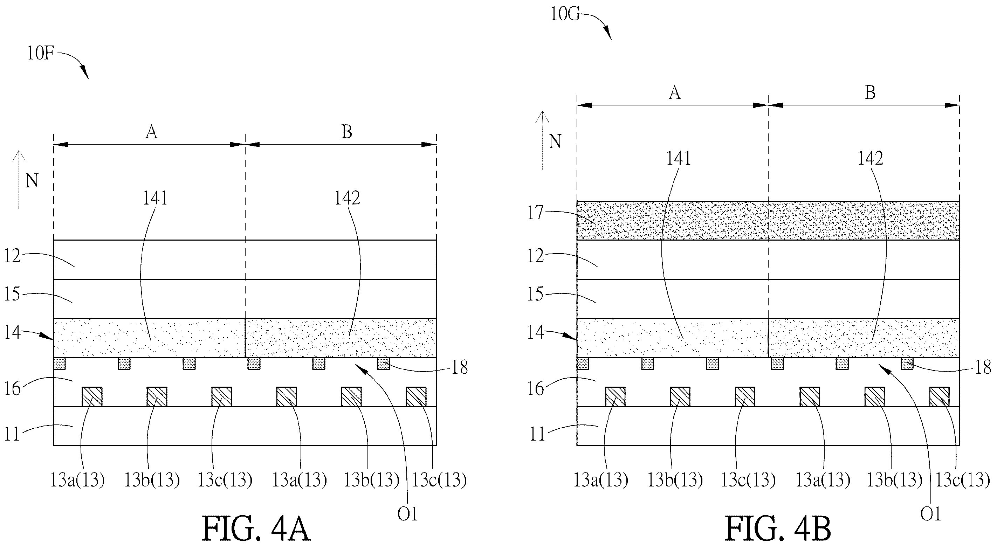

As shown in FIG. 4A, compared with the previous embodiment of FIG. 2A, the electronic device 10F further includes a black matrix layer 18, which is disposed between the electronic unit 13 and the phase retardation layer 14. The black matrix layer 18 includes a first opening O1, which overlaps the electronic unit 13 in the normal direction N of the first substrate 11. In this embodiment, the black matrix layer 18 is disposed at one side of the phase retardation layer 14 close to the electronic unit 13. In this case, a layer of black photoresist can be formed on one side of the phase retardation layer 14, and then parts of the layer of black photoresist corresponding to the light-emitting elements 13a, 13b and 13c of the electronic unit 13 are removed, thereby forming the black matrix layer 18 having a plurality of first openings O1. To be noted, the width of each first opening O1 may be equal to or slightly greater than the width of the corresponding light-emitting element 13a, 13b or 13c, and this invention is not limited thereto. The detailed description of other features of the electronic device 10F can refer to the previous embodiment, and will be omitted here.

As shown in FIG. 4B, compared with the previous embodiment of FIG. 4A, the electronic device 10G further includes an anti-reflective layer 17, which is disposed at one side of the second substrate 12 away from the electronic unit 13. The detailed description of other features of the electronic device 10G can refer to the previous embodiment, and will be omitted here.

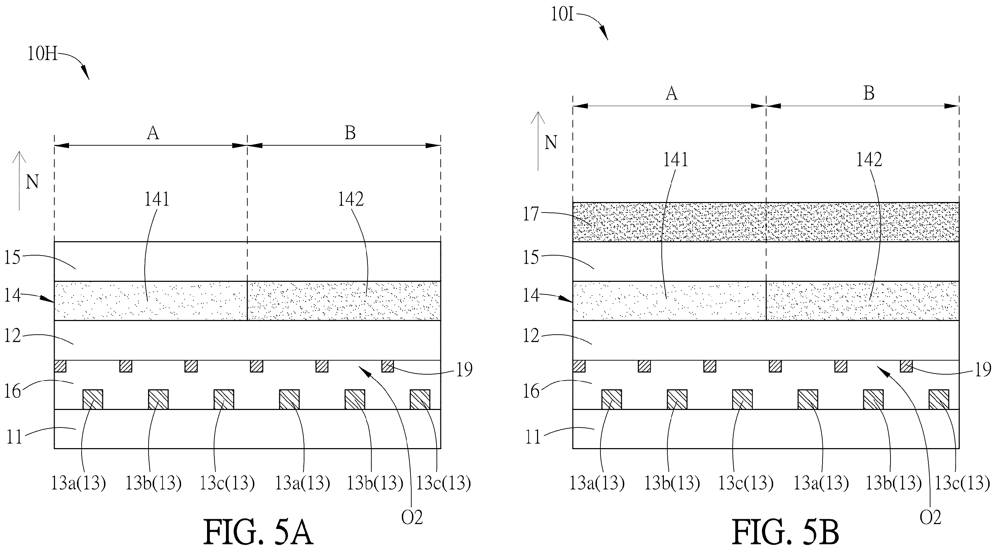

As shown in FIG. 5A, compared with the previous embodiment of FIG. 1A, the electronic device 10H further includes a reflective layer 19, which is disposed between the electronic unit 13 and the phase retardation layer 14. The reflective layer 19 includes a second opening O2, which overlaps the electronic unit 13 in the normal direction N of the first substrate 11. In this embodiment, the reflective layer 19 is disposed at one side of the second substrate 12 close to the electronic unit 13. In this case, a layer of reflective material can be formed on one side of the second substrate 12, and then the parts of the layer of reflective material corresponding to the light-emitting elements 13a, 13b and 13c of the electronic unit 13 are removed, thereby forming the reflective layer 19 having a plurality of second openings O2. It should be noted that the width of each second opening O2 can be equal to or slightly greater than the width of the corresponding light-emitting element 13a, 13b or 13c, and this invention is not limited thereto. The material of the reflective layer 19 can be, for example, a single metal layer, a composite metal layer, a multilayer film material, or a layer of any of other suitable materials. The single metal layer may include, for example, silver, aluminum, or the likes. The composite metal layer may include, for example, a composite structure of metals and metal oxides, such as, for example but not limited to, ITO/Ag/ITO, Ag/ITO, Al/Ag/Al, Ag/Al, or the likes. The multilayer film material may include, for example, a multilayer film with at least three layers of different refractive indices, wherein the high refractivity layers and the low refractivity layers are interposed with each other. The low refractivity material can be, for example but not limited to, SiOx, and the high refractivity material can be, for example but not limited to, SiNx, niobium oxide (Nb₂O₅), or the likes.

The detailed description of other features of the electronic device 10H can refer to the previous embodiment, and will be omitted here.

As shown in FIG. 5B, compared with the previous embodiment of FIG. 5A, the electronic device 10I further includes an anti-reflective layer 17, which is disposed at one side of the polarizing layer 15 away from the electronic unit 13. The detailed description of other features of the electronic device 10I can refer to the previous embodiment, and will be omitted here.

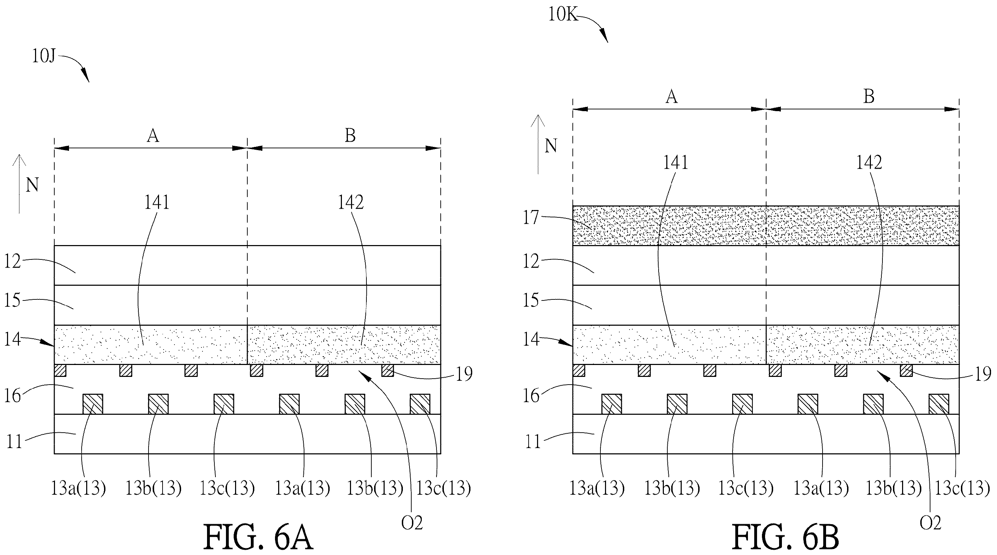

As shown in FIG. 6A, compared with the previous embodiment of FIG. 2A, the electronic device 10J further includes a reflective layer 19, which is disposed between the electronic unit 13 and the phase retardation layer 14. The reflective layer 19 includes a second opening O2, which overlaps the electronic unit 13 in the normal direction N of the first substrate 11. In this embodiment, the reflective layer 19 is disposed at one side of the phase retardation layer 14 close to the electronic unit 13. In this case, a layer of reflective material can be formed on one side of the phase retardation layer 14, and then the parts of the layer of reflective material corresponding to the light-emitting elements 13a, 13b and 13c of the electronic unit 13 are removed, thereby forming the reflective layer 19 having a plurality of second openings O2. It should be noted that the width of each second opening O2 can be equal to or slightly greater than the width of the corresponding light-emitting element 13a, 13b or 13c, and this invention is not limited thereto. The detailed description of other features of the electronic device 10J can refer to the previous embodiments, and will be omitted here.

As shown in FIG. 6B, compared with the previous embodiment of FIG. 6A, the electronic device 10K further includes an anti-reflective layer 17, which is disposed at one side of the second substrate 12 away from the electronic unit 13. The detailed description of other features of the electronic device 10K can refer to the previous embodiments, and will be omitted here.

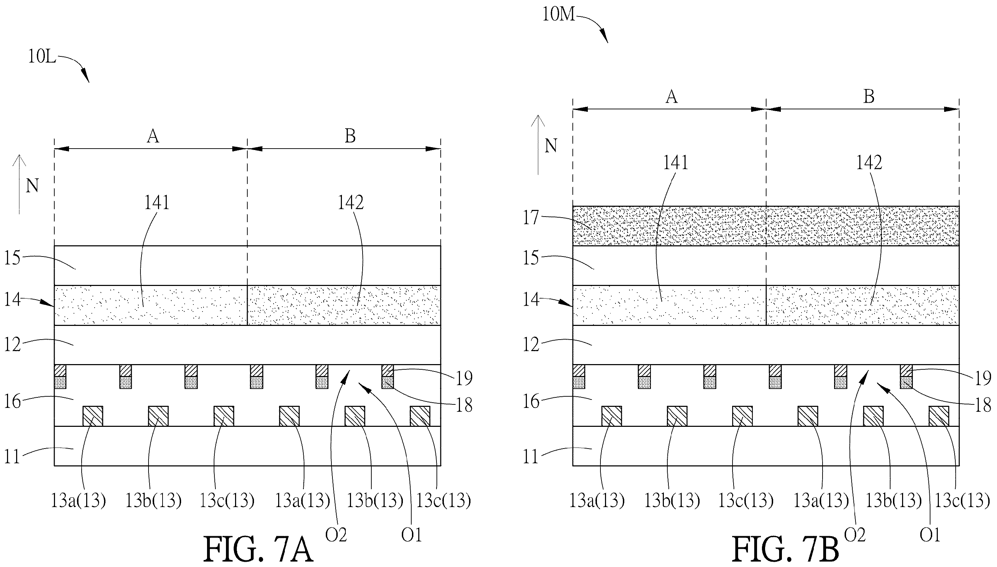

As shown in FIG. 7A, compared with the previous embodiment of FIG. 5A, the electronic device 10L further includes a black matrix layer 18, which is disposed at one side of the reflective layer 19 close to the electronic unit 13. The black matrix layer 18 includes a first opening O1, which overlaps the electronic unit 13 in the normal direction N of the first substrate 11. In this case, the first openings O1 of the black matrix layer 18 are correspondingly located under the second openings O2 of the reflective layer 19, and the second opening O2 can be equal to, slightly larger than or slightly smaller than the corresponding first opening O1. This invention is not limited thereto.

The detailed description of other features of the electronic device 10L can refer to the previous embodiments, and will be omitted here.

As shown in FIG. 7B, compared with the previous embodiment of FIG. 7A, the electronic device 10M further includes an anti-reflective layer 17, which is disposed at one side of the polarizing layer 15 away from the electronic unit 13. The detailed description of other features of the electronic device 10M can refer to the previous embodiments, and will be omitted here.

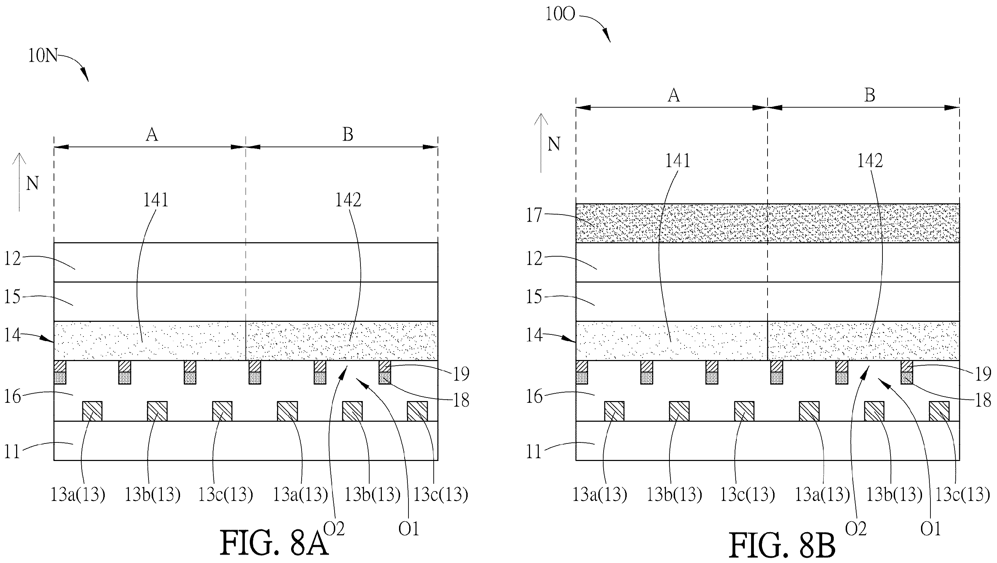

As shown in FIG. 8A, compared with the previous embodiment of FIG. 6A, the electronic device 10N further includes a black matrix layer 18, which is disposed at one side of the reflective layer 19 close to the electronic unit 13. The black matrix layer 18 includes a first opening O1, which overlaps the electronic unit 13 in the normal direction N of the first substrate 11. In this case, the first openings O1 of the black matrix layer 18 are correspondingly located under the second openings O2 of the reflective layer 19, and the second opening O2 can be equal to, slightly larger than or slightly smaller than the corresponding first opening O1. This invention is not limited thereto.

The detailed description of other features of the electronic device 10N can refer to the previous embodiments, and will be omitted here.

As shown in FIG. 8B, compared with the previous embodiment of FIG. 8A, the electronic device 10O further includes an anti-reflective layer 17, which is disposed at one side of the second substrate 12 away from the electronic unit 13. The detailed description of other features of the electronic device 10O can refer to the previous embodiments, and will be omitted here.

In summary, the electronic device of this invention includes a first substrate, a second substrate, an electronic unit, a phase retardation layer and a polarizing layer. The second substrate is disposed opposite to the first substrate. The electronic unit is disposed on the first substrate. The phase retardation layer is disposed at one side of the electronic unit away from the first substrate, and includes a first portion and a second portion disposed adjacent to each other in a direction perpendicular to the normal direction of the first substrate. The polarizing layer is disposed at one side of the phase retardation layer away from the electronic unit. In one case, the included angle between the first fast axis of the first portion and the transmission axis of the polarizing layer is different from the included angle between the second fast axis of the second portion and the transmission axis of the polarizing layer. In another case, the phase retardation of the first portion is different from the phase retardation of the second portion. Accordingly, this invention controls the angle between the first fast axis of the first portion and the transmission axis of the polarizing layer to be different from the angle between the second fast axis of the second portion and the transmission axis of the polarizing layer, and/or controls the phase retardation of the first portion to be different from the phase retardation of the second portion, in cooperating with the high reflectivity of the electronic unit and the circuit layer (e.g., including metal traces) of the first substrate, so that the area corresponding to the first portion and the area corresponding to the second portion can provide different reflected lights. Therefore, when the electronic device is not lighting, the display surface thereof can present specific colors and/or pattern designs instead of simply a black screen.

Although the invention has been described with reference to specific embodiments, this description is not meant to be construed in a limiting sense. Various modifications of the disclosed embodiments, as well as alternative embodiments, will be apparent to persons skilled in the art. It is, therefore, contemplated that the appended claims will cover all modifications that fall within the true scope of the invention.

## Claims

1. An electronic device, comprising:
a first substrate defined with a normal direction;
an electronic unit disposed on the first substrate;
a phase retardation layer disposed at one side of the electronic unit away from the first substrate, wherein the phase retardation layer comprises a first portion and a second portion disposed adjacent to each other in a direction perpendicular to the normal direction, the first portion has a first fast axis, and the second portion has a second fast axis; and
a polarizing layer disposed at one side of the phase retardation layer away from the electronic unit, wherein the polarizing layer has a transmission axis;
wherein, an included angle between the first fast axis and the transmission axis is different from an included angle between the second fast axis and the transmission axis.

2. The electronic device of claim 1, wherein the electronic unit is a light-emitting unit.

3. The electronic device of claim 1, further comprising:
a second substrate disposed opposite to the first substrate, wherein the electronic unit is disposed between the first substrate and the second substrate, and the phase retardation layer and the polarizing layer are disposed at one side of the second substrate away from the electronic unit.

4. The electronic device of claim 1, further comprising:
a second substrate disposed opposite to the first substrate, wherein the electronic unit is disposed between the first substrate and the second substrate, and the phase retardation layer and the polarizing layer are disposed at one side of the second substrate close to the electronic unit.

5. The electronic device of claim 1, further comprising:
an anti-reflective layer disposed at one side of the polarizing layer away from the electronic unit.

6. The electronic device of claim 1, wherein the first portion and/or the second portion comprise a preset pattern.

7. The electronic device of claim 1, further comprising:
a black matrix layer disposed between the electronic unit and the phase retardation layer, wherein the black matrix layer comprises a first opening, and the first opening overlaps the electronic unit in the normal direction of the first substrate.

8. The electronic device of claim 1, further comprising:
a reflective layer disposed between the electronic unit and the phase retardation layer, wherein the reflective layer comprises a second opening, and the second opening overlaps the electronic unit in the normal direction of the first substrate.

9. The electronic device of claim 8, further comprising:
a black matrix layer disposed at one side of the reflective layer close to the electronic unit, wherein the black matrix layer comprises a first opening, and the first opening overlaps the electronic unit in the normal direction of the first substrate.

10. An electronic device, comprising:
a first substrate defined with a normal direction;
an electronic unit disposed on the first substrate;
a phase retardation layer disposed at one side of the electronic unit away from the first substrate, wherein the phase retardation layer comprises a first portion and a second portion disposed adjacent to each other in a direction perpendicular to the normal direction; and
a polarizing layer disposed at one side of the phase retardation layer away from the electronic unit;
wherein, a phase retardation of the first portion is different from a phase retardation of the second portion.

11. The electronic device of claim 10, further comprising:
a second substrate disposed opposite to the first substrate, wherein the electronic unit is disposed between the first substrate and the second substrate, and the phase retardation layer and the polarizing layer are disposed at one side of the second substrate away from the electronic unit.

12. The electronic device of claim 10, further comprising:
a second substrate disposed opposite to the first substrate, wherein the electronic unit is disposed between the first substrate and the second substrate, and the phase retardation layer and the polarizing layer are disposed at one side of the second substrate close to the electronic unit.

13. The electronic device of claim 10, further comprising:
an anti-reflective layer disposed at one side of the polarizing layer away from the electronic unit.

14. The electronic device of claim 10, further comprising:
a black matrix layer disposed between the electronic unit and the phase retardation layer, wherein the black matrix layer comprises a first opening, and the first opening overlaps the electronic unit in the normal direction of the first substrate.

15. The electronic device of claim 10, further comprising:
a reflective layer disposed between the electronic unit and the phase retardation layer, wherein the reflective layer comprises a second opening, and the second opening overlaps the electronic unit in the normal direction of the first substrate.
